(19) Europäisches Patentamt
European Patent Office
Office européen des brevets

(11) Publication number: 0 390 439 A1

(12) **EUROPEAN PATENT APPLICATION**

(21) Application number: 90303141.7

(22) Date of filing: 23.03.90

(51) Int. Cl.5: C08F 2/50, G03C 1/73, G03F 7/029

(30) Priority: 27.03.89 US 328669

(43) Date of publication of application: 03.10.90 Bulletin 90/40

(84) Designated Contracting States: CH DE FR GB LI

(71) Applicant: THE MEAD CORPORATION
Mead World Headquarters Courthouse Plaza Northeast
Dayton Ohio 45463(US)

(72) Inventor: Gottschalk, Peter
71 Gershwin Drive
Centerville, Ohio 45459(US)
Inventor: Skaggs, Lisa M.
65 McVey Place
Springboro, Ohio 45066(US)

(74) Representative: Deans, Michael John Percy et al
Lloyd Wise, Tregear & CO. Norman House
105-109 Strand
London WC2R OAE(GB)

(54) **Complexes useful as photoinitiators and photohardenable compositions containing the same.**

(57) Compounds useful as photoinitiatiors and represented by the formula (I) are described:

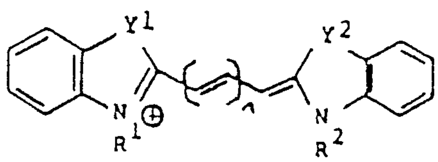
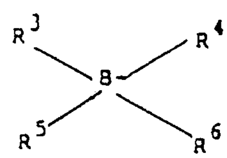

(I)

$y^1$ and $y^2$ are an oxygen atom, a sulfur atom, a selenium atom, a vinyl group, $>C(CH_3)_2$, or $N-R^7$ and may be the same or different. n is 0, 1, 2, or 3, $R^1$ and $R^2$ are alkyl groups and at least one of $R^1$ and $R^2$ is a long chain alkyl groups having at least 8 carbon atoms. $R^3$-$R^6$ are selected from alkyl, aryl, aralkyl, alkaryl, alkenyl, alkynyl, alicylic, heterocyclic and allyl groups . $R^7$ is a short chain alkyl groups.

EP 0 390 439 A1

## COMPLEXES USEFUL AS PHOTOINITIATORS AND PHOTOHARDENABLE COMPOSITIONS CONTAINING THE SAME

The present invention relates to a novel class of complexes which are useful as photoinitiators and to photohardenable compositions containing the same.

U.S. Patents 4,772,541 and 4,772,530 to The Mead Corporation disclose a novel class of photoinitiators which are compounds consisting of charged photoreducible or photooxidizable dyes and a counter ion which absorb light and generate a free radical. The preferred photoinitiators are complexes of a cationic dye and a borate anion. While these photoinitiators are suitable for many applications there is a desire to design photoinitiators which provide higher film speeds. One factor which has limited the film speeds achievable with these initiators is their limited solubility in monomers such as acrylates and methacrylates.

The present invention arises from our work seeking to provide photoinitiators which exhibit higher solubility in common monomers and provide higher film speeds.

In accordance with the invention, we provide a compound represented by the formula (I):

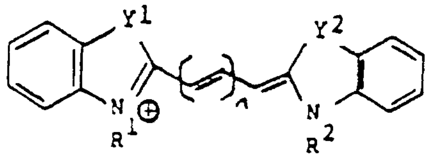 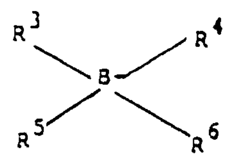 (I)

where $y^1$ and $y^2$ are an oxygen atom, a sulfur atom, a selenium atom, a vinyl group, $>C(CH_3)_2$, or $N\text{-}R^7$ and may be the same or different; n is 0, 1, 2, or 3; $R^1$ and $R^2$ are alkyl groups and at least one of $R^1$ and $R^2$ is a long chain alkyl groups having at least 8 carbon atoms; and $R^3$-$R^6$ are selected from alkyl, aryl, aralkyl, alkaryl, alkenyl, alkynyl, alicylic, heterocyclic and allyl groups, and $R^7$ is a short chain alkyl groups (i.e. 1 to 6 carbon atoms).

We believe, in addition to enhancing the solubility, having long alkyl chains for $R^1$ and $R^2$ may also increase photospeed by increasing the excited singlet state lifetime of the dye. The long chains should inhibit bond rotation within the polymethine section of the dye -- a known form of excited state deactivation. This effect would be more pronounced in viscous media as in the formulations described in detail hereinbelow.

The invention also extends to photohardenable compositions containing a photoinitiator of the formula (I); and to photosensitive material comprising a support having a layer of the aforesaid photohardenable composition on the surface thereof.

Methods useful in making photoinitiators in accordance with the present invention, and typical photohardenable compositions and photosensitive materials using same are described in U.S. Patents 4,772,530 and 4,772,541 the disclosures of each of which are to be regarded as incorporated herein by reference.

The present photoinitiators include at least one long chain alkyl group at $R^1$ and/or $R^2$. The alkyl groups represented by $R^1$ and $R^2$ may be straight chain, branched chain, or cyclic alkyl groups suitably having 1 to 20 carbon atoms, provided at least one of $R^1$ and $R^2$ contains at least 8, preferably at least 10, and more preferably at least 12 carbon atoms.

Preferably one of $R^3$-$R^6$ is an alkyl group and the others are aryl groups. Still more preferably one of $R^3$-$R^6$ is a primary or secondary alkyl group having 3 to 10 carbon atoms and the others are a phenyl group, an anisyl group, halogenated aryl group, alkylaryl group, or naphthyl group.

Preferred initiators include the following:

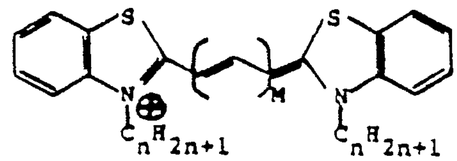

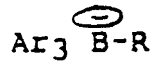

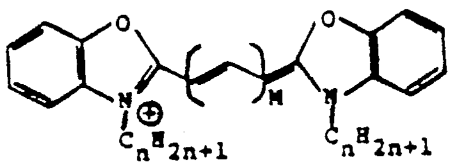

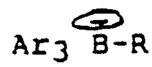

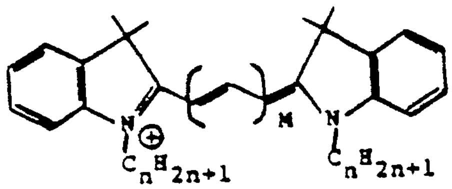

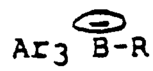

where m is 0, 1, or 2, n is greater than or equal to 8, R is a primary or secondary alkyl group having 4 to 10 carbon atoms, a cycloalkyl group having 5 to 7 carbon atoms, a benzyl group, or an allyl group and Ar is a phenyl group or an anisyl group.

As indicated in U.S. Patent 4,772,541 it is often desirable to use a coinitiator or an autoxidizer in combination with dye-borate initiators. A particularly preferred compound is a thiol selected from mercaptobenzoxazoles, mercaptotetrazines and mercaptotriazines and mercaptobenzothiazoles or an N,N-dialkylaniline as described in the aforementioned patent. Representative examples include: 2-mercaptobenzothiazole, 6-ethoxy-2-mercaptobenzothiazole, 2-mercaptobenzoxazole, 4-methyl-4H-1,2,4-triazole-3-thiol, 2-mercapto-1-methylimidazole, 2-mercapto-5-methylthio-1,3,4-thiadiazole, 5-n-butylthio-2-mercapto-1,3,4-thiadiazole, 4-methoxybenzenethiol, 1-phenyl-1H-tetrazole-5-thiol, 4-phenyl-4H-1,2,4-triazole-3-thiol, 2-mercaptobenzimidazole, pentaerythritol tetrakis (mercaptoacetate), pentaerythritol tetrakis (3-mercaptoproprionate), trimethylolpropane tris (mercaptoacetate), 4-acetamidothiophenol, mercaptosuccinic acid, dodecanethiol, 2-mercaptopyridine, 4-mercaptopyridine, 2-mercapto-3H-quinazoline, and 2-mercaptothiazoline.

The present photohardenable compositions are preferably microencapsulated and used in the full colour panchromatic imaging system described in U.S. Patent 4,772,541. A preferred method for microencapsulating the composition is described in our European Patent Application No. 88311479.5 (Publication No. EP-A-0319337). A preferred developer material is described in our European Patent Specification EP-A-0260129.

The example illustrates an embodiment of a photosensitive material in accordance with the present invention.

## Example

A. The following oily internal phase compositions were prepared and preheated to 60° C.

Internal Phase A (430 nm)

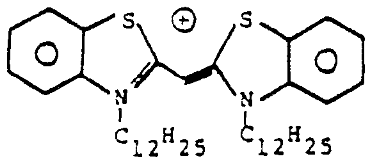

Triphenylbutyl borate (Compound 1)

| | |
|---|---|
| TMPTA | 150 g |
| Compound 1 | 2.15 g |
| DIDMA | 1.50 g |
| Reakt Yellow (BASF) | 18 g |
| Desmodur N-100 (Mobay Chemical Co.) | 10 g |

Internal Phase B (550 nm)

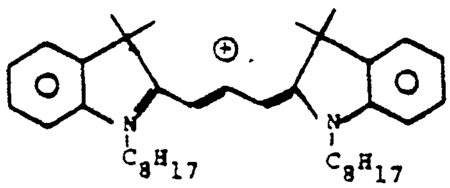

Triphenylbutyl borate (Compound 2)

| | |
|---|---|
| TMPTA | 150 g |
| Compound 2 | 0.66 g |
| DIDMA | 1.50 g |
| Magenta Color Precursor (Hilton-Davis) | 36 g |
| Desmodur N-100 | 10 g |

Internal Phase C (650 nm)

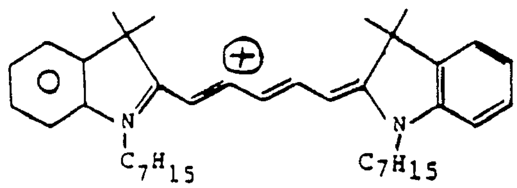

Triphenylbutyl borate (Compound 3)

| | | |
|---|---|---|
| TMPTA | 150 | g |
| 2,6 diisopropylaniline | 6.0 | g |
| Cyan color precursor (CP-177) (Hilton-Davis Chemical Co.) | 18 | g |
| Compound 3 | 0.93 | g |

B. The continuous phase for emulsification was prepared as follows and preheated to 60° C:

430g $H_2O$

8.0g Versa TL - dissolved for 15 minutes or more

12.65g Pectin - dry blended with sodium bicarbonate and dissolved into water phase

0.24g $NaHCO_3$ - dry blended with pectin and added concurrently

pH - adjusted by dropwise addition of acid and/or to pH 6.0

C. External continuous phase is brought to 3000 rpm.

D. The internal phase material was added into a mixing continuous phase.

E. 3000 rpm mixing maintained for 15 minutes after oil phase addition.

F. 246g melamine-formaldehyde precondensate is added to emulsion with mixing at 1500 rpm.

G. pH is adjusted to pH 6.0.

H. Reaction mixture is covered and held at 70° C for 1 hour while mixing.

I. 46.2g Urea @ 50% solution is added to reaction mixture and the reaction is allowed to continue at 70° C for another 40 min. (this step scavenges unreacted formaldehyde.)

J. The pH is adjusted to about 9.5 with NaOH (20% solution), covered and allowed to cool while mixing gently.

The process is repeated for each internal phase composition to prepare three batches of microcapsules. Once prepared, the microcapsules are blended in an amount which provides good color balance, coated on a sheet of aluminized polyethylene terephthalate, and dried to provide a visible light sensitive, panchromatic photosensitive material.

## Claims

1. A compound represented by the formula (I):

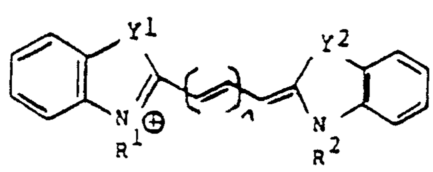 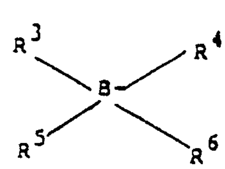 (I)

where $Y^1$ and $y^2$ are an oxygen atom, a sulfur atom, a selenium atom, a vinyl group, $>C(CH_3)_2$, or $N\text{-}R^7$ and may be the same or different; n is 0, 1, 2, or 3; $R^1$ and $R^2$ are alkyl groups and at least one of $R^1$ and $R^2$ is

a long chain alkyl groups having at least 8 carbon atoms; and $R^3$-$R^6$ are selected from alkyl, aryl, aralkyl, alkaryl, alkenyl, alkynyl, alicylic, heterocyclic and allyl groups, and $R^7$ is a short chain alkyl groups (i.e. 1 to 6 carbon atoms).

2. A compound according to Claim 1 when one of $R^3$-$R^6$ is an alkyl group and the others are each an aryl group.

3. A compound according to Claim 1, wherein one of $R^3$-$R^6$ is an alkyl group and the others are each phenyl groups.

4. A compound according to any preceding claim, wherein $R^1$ and $R^2$ each contain at least 10 carbon atoms.

5. A compound according to Claim 4, wherein $R^1$ or $R^2$ each contain at least 12 carbon atoms.

6. A photohardenable composition comprising: a free radical polymerizable or crosslinkable compound and a compound according to any preceding claim.

7. Photosensitive material comprising a support having a layer of a photohardenable composition according to Claim 6 on the surface thereof.

8. Photosensitive material according to Claim 7, wherein said photohardenable composition is microencapsulated.

European Patent Office

# EUROPEAN SEARCH REPORT

Application number

EP 90303141.7

## DOCUMENTS CONSIDERED TO BE RELEVANT

| Category | Citation of document with indication, where appropriate, of relevant passages | Relevant to claim | CLASSIFICATION OF THE APPLICATION (Int Cl 5) |
|---|---|---|---|
| X | EP - A1 - 0 223 587 (THE MEAD CORPORATION) * Claims 1,10-16; examples; page 4, lines 34-50 * | 1-8 | C 08 F 2/50<br>G 03 C 1/73<br>G 03 F 7/029 |
| X | EP - A2 - 0 308 274 (THE MEAD CORPORATION) * Claims 1,9-16 * | 1-7 | |
| X,D | US - A - 4 772 541 (GOTTSCHALK et al.) * Claims 1-12; abstract * | 1-8 | |
| A | EP - A2 - 0 109 773 (MINNESOTA MINING AND MANUFACTURING COMPANY) * Claims 1,2; example 1 * | 1-7 | |
| A | US - A - 4 343 891 (AASEN et al.) * Claims 1,2,12-15,19,21,22; examples * | 1-7 | **TECHNICAL FIELDS SEARCHED (Int Cl 5)** |
| A | US - A - 4 447 521 (TIERS et al.) * Claims 1,3,9; examples * | 1-7 | C 08 F 2/00<br>G 03 C 1/00<br>G 03 F 7/00 |
| A | US - A - 4 307 182 (DALZELL et al.) * Claims 1-12; abstract * | 1-7 | |

The present search report has been drawn up for all claims

| Place of search | Date of completion of the search | Examiner |
|---|---|---|
| VIENNA | 12-06-1990 | PUSTERER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document